(19) **Europäisches Patentamt**
**European Patent Office**
**Office européen des brevets**

(11) **EP 2 933 883 B1**

(12) **FASCICULE DE BREVET EUROPEEN**

(45) Date de publication et mention
de la délivrance du brevet:
**10.10.2018 Bulletin 2018/41**

(21) Numéro de dépôt: **15160392.5**

(22) Date de dépôt: **23.03.2015**

(51) Int Cl.:
$H01S\ 3/0941$ (2006.01)  $H01S\ 3/16$ (2006.01)
$H01S\ 5/40$ (2006.01)  $H01S\ 3/081$ (2006.01)
$H01S\ 3/06$ (2006.01)  $H01S\ 3/08$ (2006.01)
$H01S\ 3/113$ (2006.01)

(54) **CAVITÉ LASER INSTABLE À DÉCLENCHEUR PASSIF POURVU D'UN ABSORBANT SATURABLE À GRADIENT D'ABSORPTION**

INSTABILE LASERRESONANZKAVITÄT MIT PASSIVEM AUSLÖSER, DER MIT SÄTTIGUNGSFÄHIGEM ABSORPTIONSMATERIAL MIT ABSORPTIONSGEFÄLLE AUSGESTATTET IST

UNSTABLE LASER CAVITY WITH PASSIVE TRIGGER PROVIDED WITH A SATURABLE ABSORBER WITH ABSORPTION GRADIENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.03.2014 FR 1400744**

(43) Date de publication de la demande:
**21.10.2015 Bulletin 2015/43**

(73) Titulaire: **Compagnie Industrielle des Lasers Cilas 45100 Orléans (FR)**

(72) Inventeur: **Montagne, Jean-Eucher 45000 ORLEANS (FR)**

(74) Mandataire: **Gevers & Orès 41 avenue de Friedland 75008 Paris (FR)**

(56) Documents cités:
**CA-A1- 1 164 990     US-A- 5 388 114
US-A1- 2003 161 375     US-A1- 2007 068 475
US-A1- 2009 016 385     US-A1- 2010 309 936**

**Description**

La présente invention concerne une cavité laser instable à déclencheur passif, et une source laser pourvue d'une telle cavité laser.

On sait qu'une cavité laser a pour fonction d'engendrer et d'extraire un rayonnement laser et comporte, à cet effet, notamment :

- des miroirs se faisant face de manière à délimiter ladite cavité laser ; et
- au moins un élément actif (ou amplificateur laser), qui est agencé entre ces miroirs et qui est susceptible d'absorber un faisceau de pompage pour amplifier un faisceau laser se propageant selon un axe de propagation.

On sait, en outre, que des lasers pourvus de cavités laser fonctionnant en régime déclenché sont capables de délivrer des impulsions lumineuses courtes, généralement dans la gamme d'une à quelques dizaines de nanosecondes, et de forte puissance crête, couramment supérieure au mégawatt. Les applications de ce type de lasers sont multiples, à la fois dans le domaine civil (lasers scientifiques (pompage de lasers accordables par exemple), gravure, marquage,...) et dans le domaine militaire (désignation, télémétrie,...). Dans la plupart des cas, le déclenchement de ces lasers est réalisé, soit de façon active par un dispositif électro-optique ou acousto-optique (déclencheur actif), soit de façon passive par un composant à absorption saturable (déclencheur passif).

Les déclencheurs actifs présentent plusieurs avantages par rapport aux déclencheurs passifs : maîtrise de l'instant de déclenchement (mieux que la nanoseconde), faible décalage (« jitter ») temporel, et rendement d'extraction plus élevé. En revanche, ces déclencheurs actifs nécessitent une électronique qui, sans être sophistiquée, ajoute de la complexité, de l'encombrement, du poids et du coût au déclencheur.

Les documents US2010/0309936 A1 et US2003/0161375 A1 divulguent des cavités laser instables pourvues d'un déclencheur passif à gradient d'absorption.

La présente invention a pour objet une cavité laser instable qui permet de remédier à ces inconvénients, et qui est définie par les caractéristiques techniques divulguées par la revendication 1.

A cet effet, selon l'invention, la cavité laser instable pourvue d'un déclencheur passif, est remarquable en ce que le déclencheur passif comprend un absorbant saturable qui présente un gradient d'absorption, c'est-à-dire dont le profil d'absorption est inhomogène sur la section de faisceau circulant dans la cavité laser.

Ainsi, grâce à l'utilisation d'un absorbant saturable dont le profil d'absorption est inhomogène sur la section, on peut prévoir un profil d'absorption qui est tel que l'absorption résiduelle soit quasiment nulle sur une partie de section où l'essentiel de l'énergie est extraite, c'est-à-dire généralement sur les bords de l'élément actif pompé. La combinaison d'une cavité instable, dont l'extraction de l'énergie est généralement réalisée par diffraction sur la périphérie d'un miroir de couplage, avec un tel déclencheur passif à absorbant saturable à gradient d'absorption (pour lequel une absorption résiduelle est quasiment nulle), conduit à un rendement proche de celui fourni par une cavité instable comprenant un déclencheur actif, sans pour autant présenter les inconvénients d'un tel déclencheur actif : complexité, encombrement, poids et coût.

Aussi, dans le cas où le décalage (« jitter ») temporel n'est pas un élément critique, on dispose ainsi d'une cavité laser permettant d'obtenir un rendement d'extraction proche de celui qui est atteint avec un déclencheur actif.

Ladite cavité laser selon l'invention présente les caractéristiques suivantes :

- l'absorbant saturable présente un gradient d'absorption radial avec une absorption plus importante au centre que vers les extrémités radiales ;
- le déclencheur passif est dopé selon un gradient de dopage permettant de créer le gradient d'absorption ; et optionnellement :

  - la cavité laser est de type confocal.

Dans un mode de réalisation particulier, le déclencheur passif est intégré dans un milieu actif, en particulier un barreau laser, de la cavité laser. Avantageusement, dans une première variante de réalisation, ledit milieu actif est de type céramique et comporte une pièce constituant le déclencheur passif, et dans une seconde variante de réalisation, le milieu actif comprend, en plus d'un dopage principal destiné à une émission laser, un dopage secondaire présentant un gradient de dopage et permettant de créer le déclencheur passif.

Dans ce mode de réalisation particulier, de façon avantageuse, le déclencheur passif est agencé à une extrémité longitudinale aval du milieu actif ou longitudinalement dans le milieu actif allongé (en étant alors centré sur l'axe longitudinal du milieu actif).

La présente invention concerne également une source laser comportant au moins :

- une cavité laser comprenant au moins un élément actif (ou milieu actif) ;
- un système de pompage pour émettre au moins un faisceau de pompage ; et
- un système optique de transport pour diriger le faisceau de pompage vers l'élément actif (ou milieu actif) de la cavité laser.

Selon l'invention, ladite source laser comporte au moins une cavité laser instable pourvue d'un déclencheur passif (à absorbant saturable présentant un gradient d'absorption) tel que décrit dans la revendication 1.

Les figures du dessin annexé feront bien comprendre comment l'invention peut être réalisée. Sur ces figures, des références identiques désignent des éléments semblables.

La figure 1 illustre schématiquement une cavité laser conforme à un mode de réalisation de l'invention.
La figure 2 est un schéma montrant des caractéristiques d'une lentille (ou pastille) absorbante particulière d'un déclencheur passif.
Les figures 3A à 3D montrent différents exemples de réalisation de lentilles absorbantes d'un déclencheur passif.
Les figures 4A à 4C présentent différents exemples de réalisation d'un absorbant saturable à gradient d'absorption.
Les figures 5 et 6 montrent un milieu actif d'une source laser intégrant un déclencheur passif à absorbant saturable à gradient d'absorption, respectivement selon deux modes de réalisation différents.

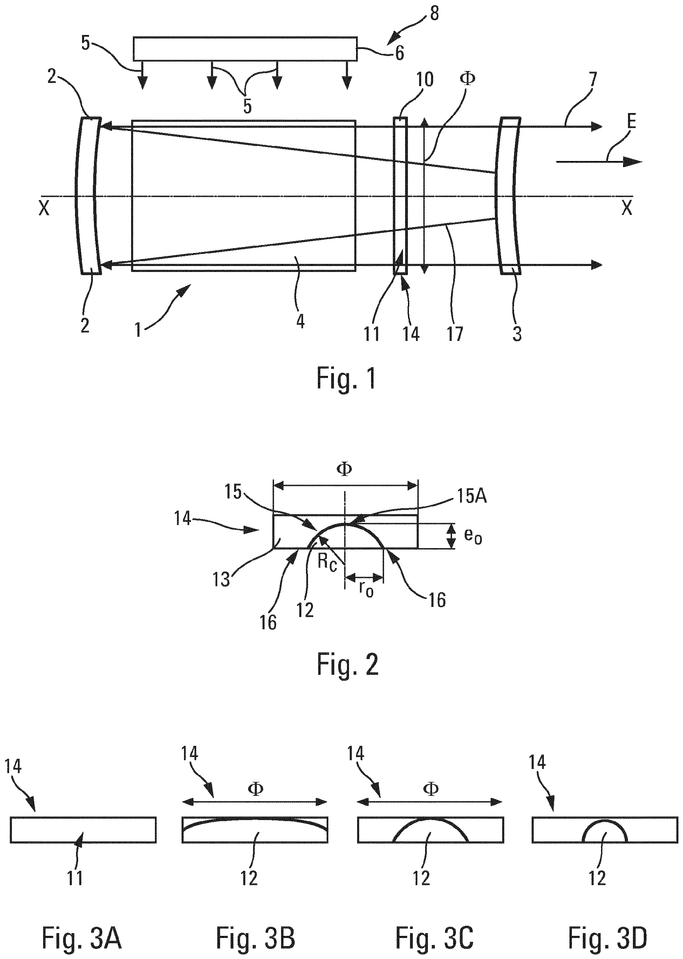

La cavité laser 1 illustrant un mode de réalisation de l'invention et représentée schématiquement sur la figure 1, comporte, de façon usuelle :

- des miroirs 2 et 3 qui se font face et qui délimitent cette cavité laser 1 ; et
- un milieu actif 4 (par exemple un barreau laser) cylindrique, allongé selon un axe X-X. Ce milieu actif 4 est un élément amplificateur (ou élément actif) et il comprend un matériau dopé susceptible d'absorber un faisceau de pompage (illustré par des flèches 5) émis par un système de pompage 6 pour amplifier un faisceau laser 7 correspondant qui est extrait de la cavité laser 1 (d'axe X-X).

Cette cavité laser 1 est de type instable. De façon usuelle, dans une cavité laser instable, un faisceau lumineux 17 circulant dans la cavité, s'éloigne de l'axe optique (axe X-X) au fur et à mesure de sa propagation, comme représenté sur la figure 1. Une partie du faisceau 17 circulant dans la cavité 1, généralement la partie radialement externe par rapport à l'axe optique X-X, est transmise hors de la cavité 1 par un élément optique (miroir 3) prévu à cet effet pour former le faisceau laser 7 extrait ou utile.

La cavité laser 1 (ou cavité optique) représentée schématiquement sur la figure 1, est destinée à être utilisée dans une source laser 8.

Une telle source laser 8 comporte, de façon usuelle, en plus de ladite cavité laser 1, notamment :

- le système de pompage 6, qui comprend des moyens usuels, par exemple des diodes de pompage (non représentées), susceptibles d'émettre au moins un faisceau de pompage 5 ; et
- un système optique de transport usuel (non représenté), qui est destiné à diriger le faisceau de pompage 5 émis par le système de pompage 6 dans ladite cavité laser 1, de manière à réaliser le pompage du milieu actif 4.

La cavité laser 1 confère au faisceau laser 7 qui est extrait de la manière précisée ci-dessous, ses caractéristiques de directivité (flèche E) et de géométrie.

De plus, ladite cavité laser 1 de type instable fonctionne en régime déclenché et elle est pourvue à cet effet d'un déclencheur passif 10.

Selon l'invention, le déclencheur passif 10 comprend un absorbant saturable 11 qui présente un gradient d'absorption. Ceci signifie que l'absorbant saturable 11 du déclencheur passif 10 présente des caractéristiques d'absorption non homogènes, c'est-à-dire comprenant un profil d'absorption qui est inhomogène, et ceci sur la section (transversalement à l'axe X-X) de faisceau circulant dans la cavité laser 1. L'absorption varie donc en fonction de la localisation sur la section.

Selon l'invention, l'absorbant saturable 11 présente un gradient d'absorption radial, avec une absorption plus importante au centre (au niveau de l'axe X-X) qu'aux extrémités radiales.

Dans le cadre de la présente invention, l'adjectif radial est défini par rapport à l'axe X-X, transversalement à ce dernier.

De façon usuelle, un absorbant saturable est un absorbant, dont le coefficient d'absorption peut varier de façon réversible sous l'effet d'un flux lumineux suffisamment intense de fréquence déterminée. Le fonctionnement d'un absorbant saturable repose sur l'effet optique non linéaire de transparence induite par voie optique : un milieu opaque à l'état initial devient transparent lorsque le rayonnement auquel il est soumis devient suffisamment intense. Pour déclencher une source laser par absorbant saturable, le matériau utilisé pour l'absorbant saturable 11 doit présenter une absorption à la longueur d'onde émise par la source laser, et le coefficient d'absorption à cette longueur d'onde doit diminuer sous l'effet d'un rayonnement suffisamment intense à cette longueur d'onde.

Dans le mode de réalisation représenté sur la figure 1, la cavité laser instable 1 est confocale à branche positive avec un miroir de couplage 3 de type supergaussien (c'est-à-dire qui présente une réflectivité variable dont la courbe de réflectivité est supergaussienne), de sorte que le faisceau laser 7 de sortie est collimaté.

Le déclencheur passif 10 à gradient d'absorption est placé juste avant le miroir de couplage 3 dans le sens E (défini par le sens d'extraction du faisceau laser 7) et son maximum d'absorption est centré sur l'axe X-X de la cavité laser 1.

Ainsi, grâce à l'utilisation d'un absorbant saturable 11 dont le profil d'absorption est inhomogène sur la section, on prévoit un profil d'absorption qui est tel que l'absorption résiduelle soit quasiment nulle sur une partie de section où l'essentiel de l'énergie est extraite, c'est-à-dire généralement sur les bords du miroir de couplage 3. La combinaison d'une cavité laser instable 1, dont l'extraction de l'énergie est généralement réalisée par diffraction sur la périphérie du miroir de couplage 3, avec un tel déclencheur passif 10 à absorbant saturable à gradient d'absorption (pour lequel l'absorption résiduelle est quasiment nulle), conduit à un rendement proche de celui fourni par une cavité instable 1 avec un déclencheur actif, sans pour autant présenter les inconvénients d'un tel déclencheur actif.

Grâce à la cavité laser 1 instable, l'extraction de l'énergie emmagasinée dans la totalité du volume pompé s'effectue avec un rendement optimal tout en garantissant une excellente discrimination du mode fondamental par rapport aux modes d'ordre plus élevé.

Dans un premier mode de réalisation particulier, pour obtenir le gradient d'absorption du déclencheur passif 10, l'absorbant saturable 11 dudit déclencheur passif 10 est dopé de façon inhomogène, c'est-à-dire avec une concentration de dopage variable. Le déclencheur passif 10 est dopé selon un gradient de dopage permettant de créer le gradient d'absorption, de préférence avec un dopage radial décroissant du centre (au niveau de l'axe X-X) vers les extrémités radiales.

Dans un second mode de réalisation particulier, pour obtenir le gradient d'absorption du déclencheur passif 10, l'absorbant saturable (dopé de façon homogène) présente une variation d'absorption qui est générée par une variation radiale de son épaisseur. L'absorbant saturable est ainsi physiquement équivalent à une lentille 12 convergente plan-convexe, comme représenté sur la figure 2. Pour que cette lentille 12 n'ait pas d'effet notable sur la stabilité de la cavité laser 1, elle est noyée dans un milieu 13 de même indice pour former une lame 14 à faces parallèles. Une telle configuration permet de contrôler plusieurs paramètres dimensionnant, comme par exemple la dimension de la lentille absorbante et l'influence de sa forme. Suivant le rayon de courbure de la lentille absorbante 12 et son diamètre, on peut obtenir des éléments différents représentés schématiquement sur les figures 3A à 3D.

Dans l'exemple de la figure 2, la lentille (ou pastille) absorbante 12 n'occupe pas la totalité de l'ouverture. On prévoit que sa forme se réduit à une calotte sphérique 15 (pas de surépaisseur sous la face plane de la lentille). L'absorption tombe donc à zéro à la périphérie 16 de la lentille 12.

L'épaisseur e de la calotte sphérique 15 (ou lentille 12) traversée par la lumière, en fonction de la position radiale r (par rapport à l'axe X-X), est donnée par l'expression suivante :

$$e = e_0 - f(r) = e_0 - (R_C - \sqrt{R_C^2 - r^2}) \text{ avec } r \le r_0 \text{ et } r_0 \le \phi/2$$

dans laquelle $e_0$ est l'épaisseur au centre (X-X) de la lentille 12 et $R_C$ le rayon de courbure de la face 15A convexe de la calotte sphérique 15. Le diamètre d'ouverture du faisceau est $\phi$ et le rayon de la lentille 12 est $r_0$.

Suivant la valeur du rayon de courbure $R_C$ de la lentille absorbante 12 et son diamètre, on peut obtenir des caractéristiques différentes représentées schématiquement sur les figures 3A à 3D. Plus précisément :

- sur l'exemple de la figure 3A, le rayon de courbure $R_C$ est infini et l'absorbant saturable 11 est homogène ;
- sur l'exemple de la figure 3B, la lentille absorbante 12 occupe la totalité de l'ouverture $\phi$ ;
- sur l'exemple de la figure 3C, la lentille absorbante 12 occupe partiellement l'ouverture $\phi$, comme sur l'exemple de la figure 2 ; et
- sur l'exemple de la figure 3C, la lentille absorbante 12 est hémisphérique.

La transmission $T_{fs}(r)$ de la lentille 12 en fonction de la position radiale r est :

$$T_{fs}(r) = \exp(-\alpha_{fs}(e_0 - f(r))) = T_{fs0}.\exp(\alpha_{fs}(R_c - \sqrt{R_c^2 - r^2}))$$

où $\alpha_{fs}$ est le coefficient d'absorption de l'absorbant saturable formant la lentille 12 et $T_{fs0}$ la transmission au centre de la lentille 12 qui est donnée par :

$$T_{fs0} = \exp(-\alpha_{fs}.e_0)$$

On considère que cette valeur $T_{fs0}$ est la transmission au centre de la lentille 12 pour une très faible intensité lumineuse (transmission à faible signal). A l'aide de cette formule, on calcule la transmission radiale à faible signal. Dans la pratique, on mesure directement la transmission à faible signal dans une configuration d'épaisseur $e_0$ donnée et de concentration donnée, qui permettent d'évaluer un coefficient d'absorption à faible signal :

$$\alpha_{fs} = -Ln(T_{fs0})/e_0$$

Lorsque l'intensité lumineuse croît de façon importante dans la cavité 1, l'absorption diminue et la transmission idéale de l'absorbant saturable est donnée par une relation du type suivant :

$$T_i(r) = \exp(Ln(T_{fs}(r))/(1 + I/I_{sat}))$$

dans laquelle $I_{sat}$ est l'intensité de saturation de l'absorbant saturable.

Cependant, un absorbant saturable possède une transmission à saturation qui n'est jamais égale à 1. En considérant que l'absorption résiduelle à saturation est due à la présence d'absorption vers les états excités de l'élément dopant, la transmission à saturation est :

$$T_{sat} = \exp(-n_g\sigma_{exs}e)$$

où $n_g$ est la densité de population sur l'état fondamental (concentration en ions dopants), $\sigma_{ex}$ est la section efficace d'absorption vers les états excités et e l'épaisseur traversée. Dans la pratique, on mesure directement la transmission à saturation $T_{sat0}$ dans une configuration d'épaisseur $e_0$ donnée et de concentration donnée, qui permettent d'évaluer un coefficient d'absorption vers les états excités :

$$\alpha_{ex} = -Ln(T_{sat0})/e_0$$

Par conséquent, dans le cas d'un absorbant en forme de lentille sphérique 15, la transmission à saturation en fonction de la coordonnée radiale s'écrit :

$$T_{sat}(r) = T_{sat0}.\exp(\frac{Ln(T_{sat0})}{e_0}(R_C - \sqrt{R_C^2 - r^2}))$$

Globalement, un absorbant saturable réel présente une transmission instantanée donnée par la relation approchée suivante :

$$T(r) = T_{fs}(r) + (\frac{T_i(r) - T_{fs}(r)}{1 - T_{fs}(r)}).(T_{sat}(r) - T_{fs}(r))$$

A titre d'illustration, et de façon non limitative, on précise ci-après les caractéristiques et les dimensions d'un mode de réalisation particulier de la cavité laser 1, représentée sur la figure 1 :

A/ le milieu actif 4 est du grenat d'yttrium-aluminium dopé au néodyme de type Nd :YAG, de diamètre $\Phi = 0,635$ cm, de longueur $l = 8$ cm et d'indice de réfraction $n_{YAG} = 1,82$ ;

B/ la cavité laser 1 instable présente une longueur géométrique L=10 cm (selon l'axe X-X). En négligeant l'épaisseur de l'absorbant saturable (à titre indicatif : environ 2 mm), la longueur effective $L_{eff}$ de la cavité laser 1 est donc approximativement :

$$L_{eff} = (1 - \frac{1}{n_{YAG}}).L \text{ , à savoir } L_{eff} = 4,5 \text{ cm.}$$

La longueur effective $L_{eff}$ sert à la définition des miroirs de cavité 2 et 3.

C/ la définition des miroirs de cavité 2 et 3, demande d'abord que le grandissement de la cavité 1 confocale soit déterminé. Un fort grandissement permet une meilleure discrimination par rapport aux modes spatiaux d'ordre élevés, mais exige un gain élevé. Dans le cas d'un barreau de type Nd :YAG, un bon compromis situe le grandissement à une valeur comprise entre 1,25 et 2. Dans l'exemple ci-après, on choisit un grandissement m = 1,5.

Les rayons de courbure $R_1$ et $R_2$ respectivement des miroirs 3 et 2 sont déterminés à partir des relations suivantes :

a) petit miroir 3 de couplage :

$$R_1 = (\frac{-2L_{eff}}{m-1}) = 18cm$$

b) grand miroir 2 concave de fond de cavité :

$$R_2 = (\frac{2mL_{eff}}{m-1}) = 27cm$$

Il est nécessaire de configurer le miroir de couplage 3 à réflectivité variable en choisissant en particulier sa réflectivité équivalente (ce paramètre pouvant être affiné par la suite). On sait que, dans une cavité stable Nd :YAG classique, dont le miroir de couplage possède une réflectivité constante, il n'est pas nécessaire que la réflectivité soit supérieure à 0,2. La réflectivité du miroir de couplage 3 ne correspond pas à la valeur optimale, elle est choisie de façon à garder une marge de sécurité par rapport à la limite de tenue au flux des composants. On prend donc cette valeur comme réflectivité équivalente $R_{eq}$, ce qui permet de calculer le pouvoir réflecteur au centre du miroir de couplage 3 :

$$R_0 = m^2.R_{eq} = 0,45$$

L'ordre super-gaussien n est déterminé par une condition de faisceau plat en sortie de cavité, c'est-à-dire sans trou, ni surintensité au centre du faisceau. Cette condition est exprimée par la relation :

$$R_0 = (\frac{1}{m^n})$$

On en tire dans la configuration considérée :

$$n = \frac{-Ln(R_0)}{Ln(m)} = 2$$

La taille de la tache réflectrice $\omega_m$ sur le miroir 3 dépend de la taille du faisceau qui se développe dans la cavité 1. Il s'agit de trouver un équilibre entre les pertes par diffraction imposées par la diaphragmation du faisceau par le barreau 4 lui-même et l'extraction d'énergie à la périphérie du miroir de couplage 3. Généralement, l'intensité au bord du barreau 4 est choisie entre 0,2% et 13% de l'intensité au centre. De façon un peu arbitraire, et cela peut être optimisé, on choisit de situer l'intensité au bord du barreau 4 à 5% de l'intensité au centre. Dans ces conditions, si la répartition d'intensité est donnée par la relation :

$$I(r) = I_0 . \exp(-2(r/\omega_i)^2)$$

on calcule une taille de faisceau (rayon à $1/e^2$ de l'intensité $I_0$ au centre) :

$$\omega_i = 0{,}8165 . \phi / 2 = 0{,}26 cm$$

La taille de la tache réflectrice est alors déduite de la relation suivante :

$$\omega_m = \frac{\omega_i}{(m^2 - 1)^{1/2}} = 0{,}232 cm$$

D/ L'absorbant saturable 11 utilisé dans le déclencheur passif 10 peut être du $Cr^{4+}$:YAG. La transmission à faible signal au centre de l'absorbant saturable est $T_0 = 0{,}25$. Ceci est un bon compromis pour extraire l'énergie souhaitée avec la puissance de pompage disponible. La transmission à saturation est $T_{sat} = 0{,}85$, ce qui correspond à un ordre de grandeur qui est compatible avec la faible transmission $T_0$ retenue.

Par ailleurs, concernant le système de pompage 6 et les paramètres spectroscopiques, pour simplifier le calcul, le dépôt d'énergie de diodes de pompage (du système de pompage 6) est supposé uniforme dans tout le milieu actif 4 et est réalisé avec une efficacité optique de 75%. On dispose d'une puissance de pompage de 5000 watts en sortie des diodes laser. Le rendement quantique de fluorescence du Nd :YAG retenu est de 92 % et la section efficace d'émission stimulée de $2{,}7.10^{-19}$ $cm^2$.

Une simulation numérique peut être réalisée pour une telle source laser 8, en plusieurs étapes successives E1 à E4, de manière à bien faire apparaître le gain apporté par l'introduction conforme à l'invention de l'absorbant saturable à gradient d'absorption :

E1/ l'absorbant saturable est homogène dans tout son volume (figure 3A). Sa transmission est optimisée pour extraire le maximum d'énergie à la fin de la période de pompage compte tenu de la puissance de pompage disponible ;
E2/ la transmission optimale calculée en E1 est choisie comme transmission de référence au centre du faisceau et ne sera pas changée pour la suite des calculs. On fait varier le rayon de courbure $R_C$ de la sphère absorbante entre l'infini (transmission homogène : figure 3A) et une valeur $R_{CB}$, de façon à avoir une transmission nulle au bord du faisceau, avec :

$$R_{CB} = \frac{\phi^2 + e_0^2}{2 e_0}$$

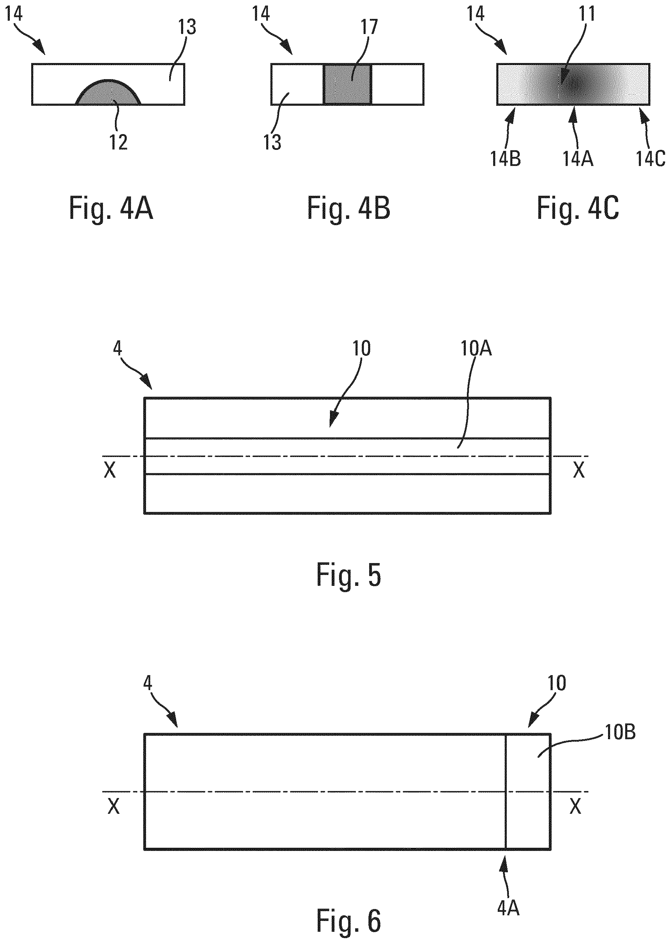

E3/ le rayon de courbure de la sphère 12 est ensuite diminué jusqu'à une valeur minimale qui correspond à l'épaisseur de la lame absorbante 14 ($e_0$: lentille hémisphérique), ce qui revient à diminuer le diamètre de la zone absorbante de $\phi$ à $2e_0$ (figure 3C). Avec cette méthode, pour parvenir à un diamètre absorbant très petit, on choisit une épaisseur de lame 14 suffisamment fine et donc une forte concentration (fort coefficient d'absorption) de l'absorbant saturable. Dans une réalisation concrète, la petite hémisphère absorbante 12 peut être remplacée, par exemple, par un gradient radial de concentration (figure 4C) ;
E4/ dans le but d'avoir une idée de l'influence de la forme du gradient, on fixe le diamètre de la lentille absorbante à la valeur $e_0$ et on change le rayon de courbure de la sphère entre l'infini et la valeur minimale $e_0$.

Par une simulation numérique, on obtient les résultats suivants :

A) résultats de l'étape E1 (figure 3A) : pour un absorbant saturable homogène de transmission $T_0 = 0{,}25$ , l'énergie émise est de 103 mJ ;
B) résultats de l'étape E2 (figure 3B) : l'absorbant saturable occupe la totalité du diamètre du barreau 4, mais sa transmission varie du centre au bord en fonction du rayon de courbure de la lentille 12 dopée. Il s'avère que la diminution de l'épaisseur d'absorbant sur les bords du faisceau améliore le rendement laser ;
C) résultats de l'étape E3 (figure 3C) : le diamètre de la lentille absorbante varie entre le diamètre du barreau 4 et un diamètre de 0,2 mm. Pour les petits diamètres, l'épaisseur au centre est adaptée tout en gardant la transmission à faible signal constante ($T_0 = 0{,}25$). L'accroissement de l'énergie émise est important lorsque la zone absorbante est réduite, elle atteint plus de 45% par rapport à la situation où on utilise un absorbant homogène. Cependant, de tous petits diamètres absorbants sont difficiles à mettre en oeuvre. Or, il s'avère qu'un diamètre de 1/3 de celui du barreau 4 est tolérable sans grande perte ;

D) résultats de l'étape E4 : dans le cas d'une lentille 12 de diamètre 2mm, trois rayons de courbure différents de la lentille ont été testés : $R_C$ infini, $R_C$ = 1,25mm et $R_C$ = 1mm. Pour chacune des ces valeurs, l'énergie émise calculée, est respectivement 139,8$mJ$, 141,8$mJ$, 142,8$mJ$. L'effet de forme du gradient sur l'énergie émise est donc négligeable.

Par conséquent, il s'avère :

- que le passage d'un déclencheur passif homogène à un déclencheur à gradient d'absorption permet un gain important sur l'énergie émise par une cavité instable 1. Le gain est de l'ordre de 40% dans le cas pris comme exemple ;
- que la taille de la zone absorbante n'a pas à être très petite. Typiquement, on gagne peu en diminuant son diamètre à une valeur inférieure à 1/3 du diamètre du barreau 4, soit 2 mm environ dans l'exemple considéré ; et
- que la forme du gradient d'absorption a une influence quasi nulle sur l'énergie émise. Elle a éventuellement une influence sur la répartition d'intensité en champ proche dans la partie centrale du faisceau (étapes E2 et E4). La face externe de l'élément absorbant peut donc être circulaire, mais également triangulaire ou d'une autre forme.

On présente ci-après en référence aux figures 4A, 4B, et 4C, respectivement, trois modes possibles de réalisation d'un tel absorbant saturable à gradient d'absorption.

Le mode de réalisation représenté schématiquement sur la figure 9A consiste à réaliser une lentille planconvexe 12 de faible rayon de courbure en matériau absorbant dont l'épaisseur est ajustée pour obtenir la transmission $T_0$ souhaitée. La partie 13 (exactement) complémentaire est usinée dans un substrat de même nature (milieu non absorbant de même indice) pour éliminer les effets de convergence de la lentille 12. L'ensemble des deux composants 12 et 13 est donc de vergence nulle.

Le mode de réalisation représenté schématiquement sur la figure 9B consiste à intégrer une partie centrale cylindrique 17 de dopage homogène dans la lame 1.

Le mode de réalisation représenté schématiquement sur la figure 9C correspond au mode préféré. L'absorbant saturable 11 du déclencheur passif est dopé selon un gradient de dopage permettant de créer le gradient d'absorption, en l'occurrence un gradient d'absorption radial, de préférence avec une absorption plus importante au centre (au niveau de l'axe X-X) qu'aux extrémités radiales. Ce mode de réalisation présente de nombreux avantages. Le gradient radial d'absorption ne présente pas de discontinuité et la tenue au flux de la lame 14 est aussi bonne que celle d'une lame homogène. Une très légère lentille résiduelle éventuelle due au faible gradient d'indice peut être compensée si nécessaire par un polissage approprié d'une des faces. On peut envisager plusieurs méthodes de fabrication d'une telle lame 14.

Dans le cas d'une matrice cristalline dopée, comme du Cr$^{4+}$ :YAG, la réalisation du gradient de dopage est envisageable si le matériau est obtenu sous forme de céramique. Dans un matériau cristallin massif, un gradient de dopage longitudinal est faisable par chauffage par zone.

Dans le cas d'absorbants saturables à centres colorés, comme $LiF:F_2^-$, la structuration de la lame 14 peut être réalisée par irradiation sélective du centre. L'absorption par les centres colorés étant généralement assez faible, le cristal est long, typiquement plus de 20 mm.

Si le barreau 4 est constitué de céramique, la fonction d'absorbant saturable à gradient peut être intégrée dans le milieu actif 4 lui-même. On obtient alors un milieu actif 4 auto-déclencheur.

Dans ce mode de réalisation particulier, le déclencheur passif 10 est donc directement intégré dans le milieu actif 4 de la cavité laser 1, comme représenté sur les figures 5 et 6.

Dans ce mode de réalisation particulier, dans une première variante de réalisation, ledit milieu actif 4 est de type céramique et comporte une pièce 10A, 10B constituant le déclencheur 10. En outre, dans une seconde variante de réalisation (non représentée) le milieu actif 4 comprend, en plus d'un dopage principal usuel destiné à l'émission laser, un dopage secondaire présentant un gradient de dopage et permettant de créer le déclencheur passif.

Dans ce mode de réalisation particulier, le déclencheur passif 10 est :

- soit agencé longitudinalement dans le milieu actif 4 au niveau de son axe X-X, en étant centré par rapport à cet axe X-X, comme représenté sur la figure 5 pour la pièce 10A ;
- soit agencé à une extrémité longitudinale 4A du milieu actif, en l'occurrence à l'extrémité aval selon le sens E de la figure 1, comme représenté sur la figure 6 pour la pièce 10B.

## Revendications

1. Cavité laser instable pourvue d'un déclencheur passif, le déclencheur passif (10) comprenant un absorbant saturable (11) qui présente un gradient d'absorption, de sorte que le profil d'absorption de l'absorbant saturable (11) est inhomogène sur la section de faisceau (17) circulant dans la cavité laser (1), la cavité laser instable étant **caractérisée en ce que** le déclencheur passif (10) est dopé selon un gradient de dopage permettant de créer un gradient d'absorption radial, le gradient d'absorption radial présentant une absorption plus importante au centre qu'aux extrémités radiales et l'absorption étant quasiment nulle sur les bords.

2. Cavité laser selon la revendication 1, comprenant au moins un milieu actif (4),
   **caractérisée en ce que** le déclencheur passif est intégré dans ledit milieu actif (4) de la cavité laser (1).

3. Cavité laser selon la revendication 2,
   **caractérisée en ce que** ledit milieu actif (4) est de type céramique et comporte une pièce (10A, 10B) constituant le déclencheur (10).

4. Cavité laser selon la revendication 2,
   **caractérisée en ce que** le milieu actif (4) comprend, en plus d'un dopage principal destiné à une émission laser, un dopage secondaire présentant ledit gradient de dopage et permettant de créer le déclencheur passif.

5. Cavité laser selon l'une des revendications 2 à 4,
   **caractérisée en ce que** le déclencheur passif (10) est agencé à une extrémité longitudinale aval (4A) du milieu actif (4).

6. Cavité laser selon l'une des revendications 2 à 4,
   **caractérisée en ce que** le déclencheur passif (10) est agencé longitudinalement dans le milieu actif (4) allongé, en étant centré sur l'axe longitudinal (X-X) du milieu actif (4).

7. Cavité laser selon l'une quelconque des revendications précédentes,
   **caractérisée en ce qu'**elle est de type confocal.

8. Source laser comportant au moins :

   - une cavité laser (1) comprenant au moins un milieu actif (4) ;
   - un système de pompage (6) pour émettre au moins un faisceau de pompage (5) ; et
   - un système optique de transport pour diriger le faisceau de pompage (5) vers le milieu actif (4) de ladite cavité laser (1),

   **caractérisée en ce que** ladite cavité laser (1) est telle que celle spécifiée sous l'une quelconque des revendications 1 à 7.

## Patentansprüche

1. Instabile Laserresonanzkavität, die mit einem passiven Auslöser ausgestattet ist, wobei der passive Auslöser (10) ein sättigungsfähiges Absorptionsmaterial (11) umfasst, das ein Absorptionsgefälle aufweist, sodass das Absorptionsprofil des sättigungsfähigen Absorptionsmaterials (11) auf dem Strahlabschnitt (17), der in der Laserresonanzkavität (1) zirkuliert, inhomogen ist, wobei die instabile Laserresonanzkavität **dadurch gekennzeichnet ist, dass** der passive Auslöser (10) gemäß einem Dotierungsgefälle dotiert ist, wodurch die Erzeugung eines radialen Absorptionsgefälles ermöglicht wird, wobei das radiale Absorptionsgefälle im Zentrum eine höhere Absorption aufweist als an den radialen Enden und die Absorption an den Rändern quasi Null ist.

2. Laserresonanzkavität nach Anspruch 1, umfassend mindestens ein aktives Medium (4),
   **dadurch gekennzeichnet, dass** der passive Auslöser in dem aktiven Medium (4) der Laserresonanzkavität (1) integriert ist.

3. Laserresonanzkavität nach Anspruch 2,
   **dadurch gekennzeichnet, dass** das aktive Medium (4) keramischer Art ist und ein Teil (10A, 10B) beinhaltet, das den Auslöser (10) bildet.

4. Laserresonanzkavität nach Anspruch 2,
**dadurch gekennzeichnet, dass** das aktive Medium (4) zusätzlich zu einer Hauptdotierung, die zu einer Laseremission bestimmt ist, eine Sekundärdotierung umfasst, die das Dotierungsgefälle aufweist und die Erzeugung des passiven Auslösers ermöglicht.

5. Laserresonanzkavität nach einem der Ansprüche 2 bis 4, **dadurch gekennzeichnet, dass** der passive Auslöser (10) an einem stromabwärts liegenden Längsende (4A) des aktiven Mediums (4) angeordnet ist.

6. Laserresonanzkavität nach einem der Ansprüche 2 bis 4, **dadurch gekennzeichnet, dass** der passive Auslöser (10) längs im länglichen aktiven Medium (4) angeordnet ist, wobei er auf der Längsachse (X-X) des aktiven Mediums (4) zentriert ist.

7. Laserresonanzkavität nach einem der vorstehenden Ansprüche,
**dadurch gekennzeichnet, dass** sie konfokaler Art ist.

8. Laserquelle, mindestens beinhaltend:

    - eine Laserresonanzkavität (1), umfassend mindestens ein aktives Medium (4);
    - ein Pumpsystem (6) zum Aussenden mindestens eines Pumpstrahls (5); und
    - ein optisches Transportsystem, um den Pumpstrahl (5) zum aktiven Medium (4) der Laserresonanzkavität (1) zu leiten,

**dadurch gekennzeichnet, dass** die Laserresonanzkavität (1) so ist wie jene nach einem der Ansprüche 1 bis 7.

## Claims

1. Unstable laser cavity fitted with a passive Q-switch, wherein the passive Q-switch (10) comprises a saturable absorber (11) that has an absorption gradient so that the absorption profile of the saturable absorber (11) is inhomogeneous over the cross section of the beam (17) travelling in the laser cavity (1), the unstable laser cavity being **characterized in that** the passive Q-switch (10) is doped in a doping gradient for creating a radial absorption gradient, the radial absorption gradient having an absorption that is greater at the centre than at the radial ends and the absorption being almost zero on the edges.

2. Laser cavity according to claim 1, comprising at least one active medium (4),
**characterized in that** the passive Q-switch is integrated in said active medium (4) of the laser cavity (1).

3. Laser cavity according to claim 2,
**characterized in that** said active medium (4) is of the ceramic type and comprises a part (10A, 10B) constituting the Q-switch (10).

4. Laser cavity according to claim 2,
**characterized in that** the active medium (4) comprises, in addition to a main doping intended for a laser emission, a secondary doping having a doping gradient and creating the passive Q-switch.

5. Laser cavity according to one of claims 2 to 4,
**characterized in that** the passive Q-switch (10) is arranged at a downstream longitudinal end (4A) of the active medium (4).

6. Laser cavity according to one of claims 2 to 4,
**characterized in that** the passive Q-switch (10) is arranged longitudinally in the elongate active medium (4), while being centred on the longitudinal axis (X-X) of the active medium (4).

7. Laser cavity according to any one of the preceding claims,
**characterized in that** the laser cavity is of the confocal type.

8. Laser source comprising at least:

   - a laser cavity (1) comprising at least one active medium (4);
   - a pumping system (6) for emitting at least one pumping beam (5); and
   - an optical transport system for directing the pumping beam (5) towards the active medium (4) of said laser cavity (1),

   **characterized in that** said laser cavity (1) is as the one specified in any one of claims 1 to 7.

Fig. 1

Fig. 2

Fig. 3A          Fig. 3B          Fig. 3C          Fig. 3D

Fig. 4A

Fig. 4B

Fig. 4C

Fig. 5

Fig. 6

**EP 2 933 883 B1**

## RÉFÉRENCES CITÉES DANS LA DESCRIPTION

**Documents brevets cités dans la description**

- US 20100309936 A1
- US 20030161375 A1